# EUROPEAN PATENT SPECIFICATION

(11) **EP 2 128 098 B1**
(45) Date of publication and mention of the grant of the patent: **07.12.2016**
(21) Application number: 09007070.7
(22) Date of filing: 27.05.2009
(51) Int. Cl.: C03B 19/09, C30B 15/10

(54) **Method for manufacturing a silica glass crucible**
Verfahren zur Herstellung eines Quarzglastiegels
Procédé de fabrication d'un creuset en verre de silice

(30) Priority: 28.05.2008 JP 2008139449
(43) Date of publication of application: 02.12.2009
(73) Proprietor: Japan Super Quartz Corporation, Akita-shi Akita 010-0065 (JP)
(72) Inventor: Kishi, Hiroshi, Akita-shi Akita, 010-0065 (JP)
(74) Representative: Banzer, Hans-Jörg

(56) References cited:
- WO-A1-2009/017071
- JP-A- 2002 080 231
- HERAEUS QUARZGLAS GMBH & CO. KG: "Business Unit Crucibles" 27TH ANNUAL INTERNATIONAL CONFERENCE AND EXPOSITION IN EUROPE FOR SEMICONDUCTOR EQUIPMENT, MATERIALS AND SERVICES IN EUROPE (SEMICON EUROPE 2003), [Online] 1 April 2003 (2003-04-01), - 3 April 2003 (2003-04-03) pages 1-30, XP002547058 Munich Retrieved from the Internet: URL:www.siltec.ru/leaflets/crucibles.pdf> [retrieved on 2009-09-23]
- SHIN-ETSU QUARTZ PRODUCTS CO., LTD.: "Semitransparent Quartz Glass Crucible for Silicon Single Crystal Pulling Applications - The SQC series" INTERNET ARTICLE (PRODUCT DATASHEETS), [Online] 1 October 2005 (2005-10-01), XP002547059 Retrieved from the Internet: URL:www.sqp.co.jp/e/seihin/catalog/pdf/e_1 .pdf> [retrieved on 2009-09-23]

## Description

### TECHNICAL FIELD

The present invention is related to a method for manufacturing a silica glass crucible, in particular a silica glass crucible which has a high degree of roundness and which is used for pulling up a silicon single crystal used as a semiconductor material or a polycrystalline silicon used as a solar cell material.

### BACKGROUND OF THE INVENTION

A silica glass crucible is used for pulling up a silicon single crystal such as semiconductor material or a polycrystalline silicon such as a solar cell. For example, single crystal silicon is mainly manufactured by a method in which a silicon melt is produced by melting a polycrystalline silicon nugget which has been charged in a silica glass crucible, dipping a seed crystal in the silicon melt and pulling up the seed crystal. The silicon crystal used for a solar cell material is manufactured by the same pulling up method but has a lower yield of single crystallization than the silicon single crystal used for a semiconductor material.

The silicon crystal is pulled up while applying a heat uniformly to the silicon melt by rotating the silica glass crucible. In this case, if the roundness (level of roundness compared to a perfect circle) of the interior surface and exterior surface of the crucible is low, because the level of vibration of the silicon melt becomes large due to horizontal swaying when rotating the crucible, the oxygen in-plane distribution becomes non-uniform and the yield of crystallization decreases. Therefore, it is preferable that the silica glass crucible used for pulling up silicon crystal be as close to a perfect circle as possible.

A rotation mold method is known as one manufacturing method of a silica glass crucible. In this method, the crucible is manufactured by depositing silica powder to a predetermined thickness on inner surface of a crucible shaped rotation mold and this layer of silica powder is heated and melted while rotating the mold to be vitrificated (Japanese Patent Applications Laid-open Nos. S56-17996 and S56-149333). In addition, a manufacturing method of a silica glass crucible is also known in which silica powder which is partially melted is attached to the interior surface of a rotation mold (Japanese Patent Application Laid-open No. H01-148718).

In the method for manufacturing a silica glass crucible stated above, when the thickness of a silica powder layer or silica glass layer which is attached to the interior surface of a mold is uneven, the roundness of the interior surface of the glass crucible is reduced and the yield of crystallization can not be increased when pulling up the silicon crystal. In addition, because the horizontal swaying becomes larger when rotating the crucible, the yield of crystallization is reduced even when the roundness of the exterior surface of the crucible is low.

The documents Heraeus Quarzglas GmbH & Co. KG Business Unit Crucibles, Presentation at SEMICON EUROPE 2003, 27th International Conference and Exposition in Europe for Semiconductor Equipment, Materials and Services, Munich, and Shin-Etsu Quartz Products Co., Ltd. "Semitransparent Quartz Glass Crucible for Silicon Single Crystal Pulling Applications - The SQC series", Product datasheet, describe examples for silica glass crucibles and corresponding manufacturing methods according to the preamble of claim 1.

JP 2002 080231 A1 describes a method of manufacturing a silica glass crucible in which silica powder is deposited onto an interior surface of a mold and is heated.

### SUMMARY OF THE INVENTION

A method of manufacturing a silica glass crucible as defined in the independent claim is provided. The dependent claim defines an embodiment.

The present invention solves the conventional problems described above with regard to a silica glass crucible used for pulling up silicon crystal, and shows the standard of roundness of a silica glass crucible for achieving a fixed yield or above of crystallization of a silicon crystal. More specifically, the silica glass crucible shows a permitted range of roundness of the silica glass crucible for obtaining a crystallization yield of 80% or more.

The present invention has been achieved to solve the conventional problem, a silica glass crucible for pulling up a silicon crystal has a roundness Sx of an interior surface of the silica glass crucible and a roundness Sy of an exterior surface of the silica glass crucible in at least a wall part of the silica glass crucible both being 0.4 or less (Sx / M ≤ 0.4, Sy / M ≤ 0.4) to a maximum thickness M in the same measurement height as the roundness.

In at least a wall part of the silica glass crucible, because the roundness Sx of the interior surface of the crucible and the roundness Sy of the exterior surface of the crucible is 0.4 or less (Sx / M ≤ 0.4, Sy / M ≤ 0.4) to the maximum thickness M in the same measurement height as the roundness, when the crucible is used to pull up the silicon crystal, the oxygen in-plane distribution of the silicon crystal is uniform and a crystallization of more than 80% can be obtained.

Furthermore, the silica glass crucible for pulling up a silicon crystal has a distance L between the center of an interior surface of the silica glass crucible and the center of an exterior surface of the silica glass crucible in at least a wall part being 0.01 or less (L ≤ 0.01D) of the longest exterior diameter D of the silica glass crucible. Because the distance L between the center of the interior surface and the center of the exterior surface of the crucible is 0.01 of less (L ≤ 0.001 D) of the longest diameter D of the exterior surface of the crucible, the oxygen in-plane distribution of the crystal is uniform and a crystallization of more than 80% can be obtained.

In addition, a manufacturing method of the silica glass crucible according to the present invention includes depositing silica powder on an interior surface of a rotating crucible shaped mold, vitrificating by heating at a high temperature a layer of the silica powder while the mold rotates, and controlling an amount of horizontal sway of the interior surface of the mold to 0.1% or less of an interior diameter of the mold. According to the manufacturing method of the present invention, when manufacturing a silica glass crucible by a rotation mold method, by placing a dial gauge on the exterior surface of the mold and controlling the amount of horizontal sway of the interior surface to 0.1% or less of the internal diameter of the mold, it is possible to maintain the roundness (Sx ratio and Sy ratio to M, L ratio to D) of the silica glass crucible within the range stated above.

### BRIEF DESCRIPTION OF THE DRAWINGS

The above and other objects, features and advantages of this invention will become more apparent by reference to the following detailed description of silica glass crucibles that do not fall under the claimed invention and of the method of the invention taken in conjunction with the accompanying drawings, wherein:
FIG. 1 is longitudinal cross sectional view of a silica glass crucible;
FIG. 2 is a horizontal cross sectional view of a silica glass crucible;
FIG. 3 is a diagram which explains the roundness of a crucible interior surface;
FIG. 4 is a diagram which explains an axis misalignment between the center of an interior surface and the center of an exterior surface; and
FIG. 5 is a flowchart which shows an embodiment of the method of the present invention for manufacturing a silica glass crucible.

### DETAILED DESCRIPTION OF THE EMBODIMENTS

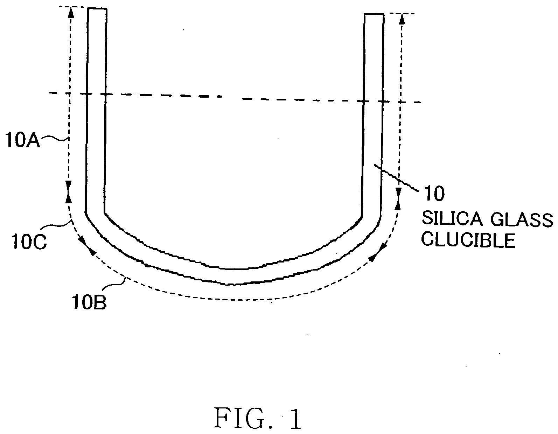

The present invention will be explained in detail below based on the silica glass crucibles. FIG. 1 is a longitudinal cross sectional view of a silica glass crucible. As shown in FIG. 1, the silica glass crucible 10 is used for pulling up a silicon crystal and includes a cylindrical wall part 10A, a bottom part 10B arranged below the wall part 10A, and a corner part 10C positioned between the wall part 10A and the bottom part 10B. In at least the wall part 10A of the silica glass crucible 10, the roundness Sx of the interior surface of the crucible and the roundness Sy of the exterior surface of the crucible are 0.4 or less (Sx / M ≤ 0.4, Sy / M ≤ 0.4) to the maximum thickness M in the same height as the height measured for the roundness Sx and Sy.

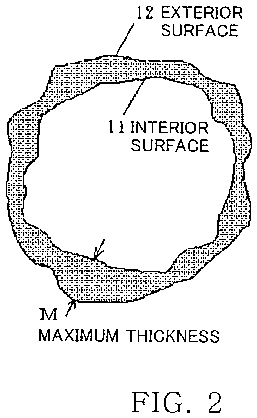

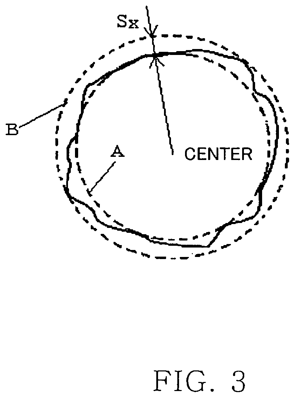

FIG. 2 is a horizontal cross sectional view of a crucible wall part (side wall) when the silica glass crucible shown in FIG. 1 is cut at an arbitrary position shown by the dashed line. Furthermore, the roundness of the interior surface 11 of the crucible in FIG. 2 is shown in FIG. 3. When the interior surface 11 is sandwiched by inner and outer concentric circles (perfect circles) A, B as is shown in FIG. 3, the roundness Sx of the interior surface 11 is expressed by a semi-diameter correction between the circle A and circle B when the interval between these concentric circles A, B is at its smallest. Circle A contacts with a part of the crucible interior surface 11 which projects the furthest inward, and circle B contacts with a part of the crucible interior surface 11 which projects the furthest outward. Although not shown in the diagram, the same as the crucible interior surface 11, when the exterior surface 12 is sandwiched by inner and outer concentric circles, the roundness Sy of the crucible exterior surface 12 is expressed by a semi-diameter correction when the interval between these concentric circles is at its smallest.

The roundness Sx of the crucible interior surface 11 and the roundness Sy of the crucible exterior surface 12 of the silica glass crucible 10 are 0.4 or less (Sx / M ≤ 0.4, Sy / M ≤ 0.4) to (refer to FIG. 2) the maximum thickness M of the crucible wall part which is measured by the same height as the roundness.

If the roundness Sx of the crucible interior surface 11 or the roundness Sy of the crucible exterior surface 12 is large, the thickness difference of the crucible wall part becomes larger and when the crucible is rotated because the horizontal sway of the silicon melt which is charged in the crucible becomes larger when the crucible is rotated. It is therefore preferable that the roundness Sx and Sy are as small as possible. The interval between the crucible interior surface 11 and the crucible exterior surface 12 is the thickness of the crucible and the roundness Sx of the interior surface and the roundness Sy of the exterior surface are related to the thickness of the crucible.

If the roundness Sx of the interior surface and the roundness Sy of the exterior surface are controlled to less than 0.4 to the maximum thickness M of the crucible wall part 10A in the same measurement height as the roundness, it is possible to make the oxygen in-plane distribution within the crystal uniform and also achieve a high yield of crystallization.

In manufacturing the silica glass crucible, although the roundness Sx of the crucible interior surface and the roundness Sy of the crucible exterior surface are made as small as possible to approach a perfect circle, in the actual manufacturing process it is difficult to produce a perfect circle. Therefore, it is a great advantage and discovery that it is sufficient to control the roundness Sx of the crucible interior surface and the roundness Sy of the crucible exterior surface to within the above stated conditional range by the present invention.

Because the fluid level of the silicon melt which is charged in the silica glass crucible gradually decreases from the side wall part (wall part) to the corner part by pulling up the silicon crystal, the crucible interior surface roundness Sx and the crucible exterior surface roundness Sy are expected to meet the above stated conditions (Sx / M ≤ 0.4, Sy / M ≤ 0.4) in at least the wall part of the crucible.

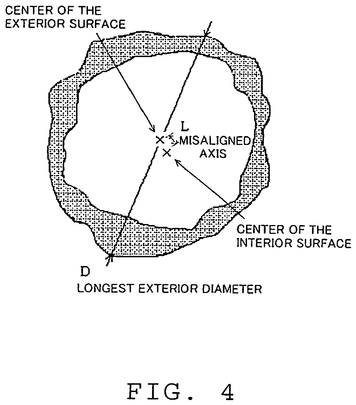

In addition, as shown in FIG. 4, in the silica glass crucible used for pulling up a silicon crystal, when the distance (misaligned axis) L from the center of the interior surface of the crucible to the center of the exterior surface of the crucible is large, the horizontal sway of the crucible when it is rotated becomes large. It is therefore preferred that this misaligned axis is made as small as possible. However, it is difficult to completely eliminate the misaligned axis in the actual manufacturing process.

Here, if the misaligned axis L stated above is 0.01 or less (L ≤ 0.01 D), or more preferably 0.005 or less (L ≤ 0.005 D) of the longest diameter D which passes through the center of the crucible exterior surface, it is possible to make the oxygen in-plane distribution within the crystal uniform and also achieve a high yield of crystallization when pulling up the silicon crystal. Because it is difficult to completely eliminate the misaligned axis in the actual manufacturing process, it is a great advantage and discovery that it is sufficient to control the misaligned axis to within the above stated conditional range.

In manufacturing the silica glass crucible by depositing silica powder on the interior surface of a rotating crucible shaped mold and vitrificating by heating this silica powder layer under a high temperature while the mold is rotating, the silica glass crucible can be manufactured by placing a dial gauge on the interior surface of the mold and controlling the amount of horizontal sway of this interior surface to less than 0.1% of the mold's interior diameter.

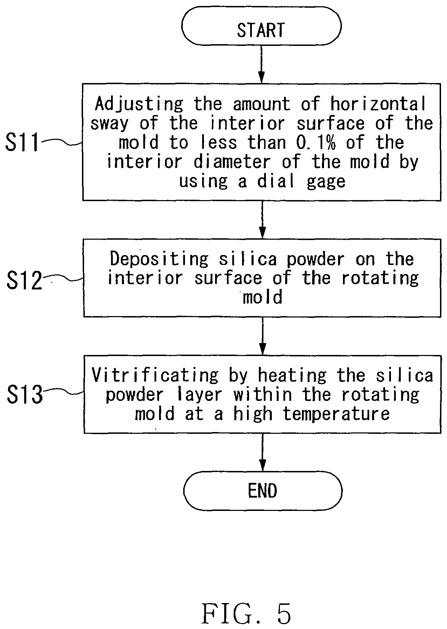

FIG. 5 is a flowchart which shows a manufacturing method of the silica glass crucible. In the manufacture of the silica glass crucible, first the amount of horizontal sway of the interior surface of the mold is adjusted while rotating the mold (step S11). At this time, the amount of horizontal sway is adjusted to less than 0.1% of the interior diameter of the mold by using a dial gauge. Next, silica powder is deposited on the interior surface of the rotating mold and a silica powder layer is formed (step S12). Following this, vitrification is performed by heating the silica powder layer within the rotating mold at a high temperature and a silica glass crucible which has the basic shape shown in FIG. 1 is formed (step S13). In a silica glass crucible manufactured in this way, because the crucible interior surface roundness Sx and the crucible exterior surface roundness Sy meet the above stated conditions (Sx / M ≤ 0.4, Sy / M ≤ 0.4) in a least the wall part of the crucible, it is possible to make the oxygen in-plane distribution within the crystal uniform and also achieve a high yield of crystallization when pulling up the silicon crystal.

The present invention is in no way limited to the aforementioned embodiments, but rather various modifications are possible within the scope of the invention as recited in the claims, and naturally these modifications are included within the scope of the invention.

For example, the silica glass crucible is effective for pilling up a silicon single crystal used as a semiconductor material because it is possible to achieve a high yield of crystallization. However, the silica glass crucible is also effective for pulling up a polycrystalline silicon used as a solar cell material because it is possible to make the oxygen in-plane distribution within the crystal uniform.

### (Examples)

The silica glass crucible which does not form part of the present invention and the method of the present invention are shown in detail using examples and comparative examples below.

### (Examples 1 - 4)

A silica glass crucible (32 inch interior diameter) was manufactured and a silicon single crystal was pulled up under the conditions shown in Table 1. At this time, the silicon single crystal was pulled up while rotating the silica glass crucible so that the silicon melt was uniformly heated and the oxygen in-plane distribution within the crystal became as uniform as possible. The rotation speed of the silica glass crucible was 5 rpm. Next, the crystallization yield and oxygen in-plane distribution within silicon single crystal which was pulled up was measured.

The oxygen in-plane distribution within the crystal was measured from four points of oxygen density in a radial direction which includes the center of a wafer cut from a silicon ingot. Usually, the oxygen density decreases gradually in a radial direction from the center of the wafer. However, this reduced amount is particularly noticeable near the periphery of the wafer. Therefore, the points to be measured are usually located at (1) center of the wafer, (2) a position r/2 (r is a radius) from the center of the wafer, (3) a position 10 mm from the periphery of the wafer, and (4) a position 5 mm from the periphery of the wafer. The oxygen in-plane distribution of a wafer was evaluated in the following way. In the case where all the measured values of these four points are within a predetermined range, more specifically, in the case where the all the measured values are within 10% ± of the oxygen density at the center of the wafer, the oxygen in-plane distribution within the crystal is considered [uniform], and in the case where these values are not within this range, the oxygen in-plane distribution within the crystal is considered [non-uniform]. For example, when the oxygen density at the center of the wafer is 12.55 (x 10¹⁷ atms / cm³), if another measured value is within the range 11.30 - 13.80 (x 10¹⁷ atms / cm³), then the oxygen density is uniform. Furthermore, the oxygen density within the crystal was measured by a Fourier transform infra-red spectrophotometer (commonly called FTIR).

The yield of crystallization was measured by the weight of the straight body part of the silicon single crystal which was pulled up divided by the weight of silicon material put into the crucible. That is, because not all of the silicon melt within the crucible is consumed and only the straight body part excluding the top part and tail part of a silicon ingot is used in the calculation of the yield of crystallization. Even if a sufficient silicon single crystal is pulled up, the crystallization yield is below 100% and favorable if more than 80%. The results of the yield of crystallization of the silicon crystal and oxygen in-plane distribution within the crystal are shown in Table 1.

### (Comparative Examples 1 - 3)

A silica glass crucible with a 32 inch interior diameter was manufactured and a silicon single crystal was pulled up under the conditions shown in Table 1. Next, the same as in the example stated above, the crystallization yield and oxygen in-plane distribution within silicon single crystal which was pulled up was measured. The results are shown in Table 1.

**(Table 1)**

| | Interior surface roundness Sx | Exterior surface roundness Sy | Maximum thickness M | Roundness ratio | | Oxygen in-plane Distribution | Crystallization yield (%) |
|---|---|---|---|---|---|---|---|
| | | | | Interior surface | Exterior Surface | | |
| Example 1 | 1.5mm | 1.7mm | 15mm | 0.10 | 0.11 | ○ | 88 |
| Example 2 | 5.3mm | 5.7mm | 15mm | 0.35 | 0.38 | ○ | 83 |
| Example 3 | 6.0mm | 3.0mm | 15mm | 0.40 | 0.20 | ○ | 80 |
| Example 4 | 3.0mm | 6.0mm | 15mm | 0.20 | 0.40 | ○ | 81 |
| Comparative Example 1 | 6.8mm | 2.1mm | 15mm | 0.45 | 0.14 | X | 52 |
| Comparative Example 2 | 1.8mm | 7.2mm | 15mm | 0.12 | 0.48 | X | 47 |
| Comparative Example 3 | 7.1mm | 7.7mm | 15mm | 0.47 | 0.51 | X | 51 |

| | | | | | | | |
|---|---|---|---|---|---|---|---|
| (note) roundness ratio is a ratio of the roundness to the maximum thickness M in the same measurement height as the roundness. "○" indicates that the oxygen in-plane distribution is uniform and "X" indicates non-uniform. | | | | | | | |

### (Examples 11 - 13)

A silica glass crucible (32 inch interior diameter) was manufactured and a silicon single crystal was pulled up under the conditions shown in Table 2. Next, the same as in the example and comparative example stated above, the crystallization yield and oxygen in-plane distribution within the silicon single crystal was measured. The results are shown in Table 2.

### (Comparative Examples 11 - 12)

A silica glass crucible with a 32 inch interior diameter was manufactured and a silicon single crystal was pulled up under the conditions shown in Table 2. Next, the same as in the example and comparative example stated above, the crystallization yield and oxygen in-plane distribution within the silicon single crystal was measured. The results are shown in Table 2.

**(Table 2)**

| | Axis misalignment L between interior surface and exterior surface | Longest diameter D of exterior surface | Axis misalignment ratio | Oxygen in-plane Distribution | Crystallization yield (%) |
|---|---|---|---|---|---|
| Example 11 | 4.1mm | 825mm | 0.005 | ○ | 88 |
| Example 12 | 5.8mm | 825mm | 0.007 | ○ | 83 |
| Example 13 | 8.3mm | 825mm | 0.010 | ○ | 80 |
| Comparative Example 11 | 9.9mm | 825mm | 0.012 | X | 65 |
| Comparative Example 12 | 12.4mm | 825mm | 0.015 | X | 43 |

| | | | | | |
|---|---|---|---|---|---|
| (note) Axis misalignment ratio is a ratio of the axis misalignment L to the longest diameter D of the exterior surface. | | | | | |

As is shown in Tables 1 and 2, in the silica glass crucible the oxygen in-plane distribution within the silicon single crystal was uniform and the yield of crystallization was high. On the other hand, in the silica glass crucible in the comparative examples the oxygen in-plane distribution within the silicon single crystal was non-uniform and the yield of crystallization was low. In addition, as is shown in examples 11 to 13, the yield of crystallization was at its highest when the axis misalignment ratio was 0.01 or less, and the larger the axis misalignment the lower the yield of crystallization became. Particularly, as is shown in example 11, the yield of crystallization was 88% when the axis misalignment ratio was 0.005 and the lower the axis misalignment the higher the yield of crystallization became.

## Claims

1. A method for manufacturing a silica glass crucible comprising:
depositing silica powder on an interior surface of a rotating crucible shaped mold; and
vitrificating by heating at a high temperature a layer of the silica powder while the mold rotates,
**characterized in that**
an amount of horizontal sway of the interior surface of the mold is controlled to 0.1% or less of an interior diameter of the mold, and
a dial gauge placed on the surface of the mold is used for adjusting the horizontal sway.

2. The method for manufacturing a silica glass crucible according to claim 1, wherein the horizontal sway is adjusted to 0.1% or less of an interior diameter of the mold before depositing silica powder on the interior surface of the rotating mold.

## Patentansprüche

1. Verfahren zur Herstellung eines Quarzglastiegels, umfassend:
Aufbringen von Silicapulver auf eine Innenfläche einer sich drehenden tiegelförmigen Form; und
Verglasen, indem bei einer hohen Temperatur eine Schicht des Silicapulvers erhitzt wird, während sich die Form dreht,
**dadurch gekennzeichnet,**
**dass** ein Umfang einer horizontalen Schwankung der Innenfläche der Form auf 0, 1 % oder weniger eines Innendurchmessers der Form geregelt wird, und
**dass** eine Messuhr, welche auf der Fläche der Form angeordnet ist, eingesetzt wird, um die horizontale Schwankung einzustellen.

2. Verfahren zur Herstellung eines Quarzglastiegels nach Anspruch 1, wobei die horizontale Schwankung auf 0,1 % oder weniger eines Innendurchmessers der Form eingestellt wird, bevor das Silicapulver auf der Innenfläche der sich drehenden Form aufgebracht wird.

## Revendications

1. Procédé de fabrication d'un creuset en verre de silice comprenant :
le dépôt d'une poudre de silice sur une surface intérieure d'un moule en forme de creuset rotatif ; et
la vitrification par chauffage à une température élevée d'une couche de la poudre de silice alors que le moule tourne,
**caractérisé en ce qu'**
une quantité de balancement horizontal de la surface intérieure du moule est commandée à 0,1 % ou moins d'un diamètre intérieur du moule et
une jauge à cadran placée sur la surface du moule est utilisée pour ajuster le balancement horizontal.

2. Procédé de fabrication d'un creuset en verre de silice selon la revendication 1, dans lequel le balancement horizontal est ajusté à 0,1 % ou moins d'un diamètre intérieur du moule avant le dépôt de poudre de silice sur la surface intérieure du moule rotatif.
